# EUROPEAN PATENT SPECIFICATION

(11) **EP 1 605 744 B1**
(45) Date of publication and mention of the grant of the patent: **05.12.2018**
(21) Application number: 05075717.8
(22) Date of filing: 29.03.2005
(51) Int. Cl.: H05K 13/02, H05K 13/04

(54) **Component placement apparatus, component feeding apparatus and method**
Bestückungsautomat für Baulelemnte, Vorrichtung zur Zuführung von Bauteilen und Methode.
Appareil de placement de composants, dispositif d'alimentation en composants et méthode

(30) Priority: 11.06.2004 EP 04102657
(43) Date of publication of application: 14.12.2005
(73) Proprietor: Assembléon B.V., 5503 LA Veldhoven (NL)
(72) Inventor: Vermeer, Adrianus Johannes Petrus Maria, 5666 BW Geldrop (NL); van de Ven, J. T. A., 5503 LA Veldhoven (NL)
(74) Representative: Veldman-Dijkers, Cornelia G. C.

(56) References cited:
- WO-A1-03/067951
- US-A- 5 498 122
- US-A1- 2002 003 995
- US-B1- 6 524 052

## Description

The invention relates to a component placement apparatus comprising a tray storing device with slots for storing trays containing electronic components, a tray transporting device for transporting a tray from the tray storing device to a pickup area, a controller for controlling the transport from the trays in and out the tray storing device and at least one component pick and place device for picking up a component from the tray located in the pickup area and placing the component on a substrate.

The invention furthermore relates to a component feeding device comprising a tray storing device with slots for storing trays containing electronic components, a tray transporting device for transporting a tray from the tray storing device to a pickup area and a controller for controlling the transport from trays in and out the tray storing device

The invention also relates to a method for optimizing the operation of a component feeding device which component feeding device comprises a tray storing device with slots for storing trays containing electronic components, a tray transporting device for transporting a tray from the tray storing device to a pickup area and a controller for controlling the transport from trays in and out the tray storing device.

Such a component placement apparatus, component feeding device and method are known from the European patent application EP-A2-0.883.333. The component placement apparatus according to this European patent application comprises a component feeding device in which a carriage comprising several slots for trays for containing electronic components is movable in an upward and downward direction. The component feeding device comprises a tray transporting device by means of which a tray located in a slot is movable in a horizontal direction to a pickup area. By means of a component pick and place device a component is picked up from the tray in the pickup area and transported to a desired location on a substrate. After one or more components are being picked up from the tray, the tray is placed back in the same slot after which the carriage is moved in a vertical direction to align another slot comprising another tray with the tray transporting device.

A disadvantage of this component placement apparatus is that the removal of empty trays as well as the insertion from new trays can only take place if the carriage is temporarily stopped. During this time no other tray can be placed in the pickup area other than the tray which is located in the slot aligned with the tray transporting device. Safety measures need to be taken to prevent that a new tray is inserted in said slot because otherwise the tray located in the pickup area cannot be placed back in the carriage.

However, a main disadvantage of this component placement apparatus is that the time necessary for moving the carriage upwards and downwards can be relatively long if for example subsequently the upper, the lower and again the upper tray is needed.

Because of the time consuming movements of the carriage the output of the component placement apparatus is relatively low.

It is an object of the invention to provide a component placement apparatus with a higher output.

This object has been achieved by the component placement apparatus according to the invention in that the tray storing device comprises a first part comprising slots for trays expected to be needed at the pickup area in the short term, which first part is located close to the pickup area, whilst the tray storing device comprises a second part comprising slots for storing trays which are empty or not expected to be needed in the pickup area in the short term which second part (18) is located further away from the pickup area, whereby the controller comprises means for determining whether a tray that is at the pick-up area and after a component has been removed from said tray at the pickup area will be needed at the pickup in the short term and should be stored in an empty slot of the first part or whether said tray is empty or not expected to be needed in the pickup area in the short term and should be stored in an empty slot (15) of the second part.

By dividing the tray storing device in at least a first and second part, the trays which are needed on short notice are located relatively close to each other due to which the time necessary to align a desired slot with respect to the tray transporting device is relatively short.

It has to be noted that EP1476006A1 discloses a component placement apparatus comprising a tray type component feeder with a number of slots located one above the other for storing trays containing electronic components. The tray type component feeder comprises magazines being movable in vertical direction to be able to position a specific tray in the magazine on the same level as a tray component feed position. The tray can than be moved from the magazine in an incoming direction to the tray component feed position. The component placement apparatus of EP1476006A1 also comprises a component feeder. If a component is being picked up from the component feeder, the tray is being moved in the outgoing direction to a retreat position in a body frame to avoid interference. By EP1476006A1 each tray is located in a specific slot in the magazine, is being moved by the magazine in vertical direction to the level of the tray component feed position, is being moved in horizontal direction towards the tray component feed position and is being moved back to the magazine to the same specific slot in the magazine. The empty slot into which the tray coming from the component feed position is being inserted, is always the empty slot located the closest to the pickup area. It is also noted that US6524052B1 discloses a tray feeder with a replenish portion to replace an empty pallet by a new full pallet. A pick-up position, the replenishing portion and a non-mounted-parts discharge portion are disposed near to one another. The non-mounted-parts discharge portion and the replenishing portion are disposed above magazines, so the magazines with pallets are located further away from the pick-up position than the replenishing portion and the non-mounted-parts discharge portion.

An embodiment of the component placement apparatus according to the invention is characterized in that the component placement apparatus is provided with safety means which allow trays to be transported by the tray transporting device from the first part to the pickup area and vice versa while simultaneously trays in the second part can be removed from the tray storing device and/or new trays can be inserted in the second part.

Due to the safety means it is possible to refill the second part of the tray storing device whilst simultaneously trays in the first part can be transferred to and from the pickup area. Safety means can be relatively simple because they only need to prevent the alignment of the tray transport device with respect to all slots of the second part.

If desired, the second part can be divided in two parts, one part with trays comprising components, which trays are expected not to be needed at the pickup area in the short term and another part comprising empty trays. This renders the removal of the empty trays relatively simple.

Another embodiment of the component placement apparatus according to the invention is characterized in that by the safety means, the tray transporting device is prevented from transporting trays from the second part, during removal to the exterior and/or insertion from the exterior of trays in the second part.

Hereby it is effectively prevented that trays can be inserted simultaneously in one and the same slot by an operator as well as by the tray transporting device.

A further embodiment of the component placement apparatus according to the invention is characterized in that a component can be picked up from the tray located in the pickup area by means of the pick and place device and can be placed on the substrate forming a buffer, whilst the component placement apparatus comprises a further pick and place device by means of which the component placed on the buffer forming substrate can be transferred to another substrate.

In this manner the further pick and place device can be used for accurately placing components from the buffer forming substrate on the other substrate whilst during this placement process, one or more components can be put ready on the buffer forming substrate. Due to this measure, the output of the accurate pick and place device will be relatively high.

Yet another embodiment of the component placement apparatus according to the invention is characterized in that the tray storing device is stationary whilst the tray transporting device is movable along the slots of the tray storing device.

Since the weight of the tray storing device will normally be much higher than the weight of the tray transporting device, it is easier to move the tray transporting device with respect to the tray storing device than the other way around. Furthermore the first part of the tray storing device will hereby have a fixed and relatively small distance to the pickup area. Also the second part of the tray storing device is stationary, meaning refill actions can be done during operation.

The invention furthermore relates to a method as indicated above, which method is characterized in that a plurality of trays comprising components are inserted in the slots of the tray storing device, whereby at least one slot is empty, after which a tray is being moved under control of the controller by means of the tray transport device to the pickup area at which location a component is being removed from the tray, subsequently it is determined by means of the controller whether the tray that is at the pick-up area and after a component has been removed from said tray at the pickup area will be needed at the pickup area in the short term after which said tray is stored in an empty slot of a first part of the tray storing device relatively close to the pickup or whether said tray is empty or not expected to be needed in the pickup area in the short term and is stored in an empty slot of a second part of the tray storing device located further away from the pickup area.

By doing so the trays which are expected to be needed in the short term are located relatively close to each other due to which the time necessary to transfer a tray from the pickup area to its slot and transfer another tray to the pickup area will be relatively short.
Another embodiment of the method according to the invention is characterized in that by means of the tray transporting device a tray in the second part, which is expected to be needed at the pickup area in the short term is transferred to a slot in the first part.

During the time that the tray transporting device is not used to present a tray in the pickup area or that the tray is left at the pickup area, the tray transporting device will be used to rearrange the order of trays in such a manner that all trays which are expected to be needed at the pickup area in the short term are located relatively close to each other.

Another embodiment of the method according to the invention is characterized in that by means of the tray transporting device a tray in the first part which is expected not to be needed in the pickup area in the short term is transferred to a slot in the second part.

In this manner trays which are expected not to be needed are transferred away from the first part to the second part in which they are stored. Empty trays which will not be needed in the pickup area are also transferred to this second part. Preferably all empty trays are positioned relatively close to each other so that an operator can remove all trays from successively slots and refill them with new trays. In this manner the time necessary for refilling the tray storing device is relatively short.

A further embodiment of the method according to the invention is characterized in that empty trays in slots in the second part are removed from the tray storing device whilst simultaneously trays in the first part are being transported to and from the pickup area.

Since the tray storing device is divided in two parts, it is relatively easy to safeguard that whilst trays are transferred by the tray transporting device from and to the first part and simultaneously the second part is being refilled no trays can be simultaneously inserted or removed by the operator as well as by the tray transporting device.

The invention will further be explained with reference to the drawings in which:
Fig. 1 is a top view of a component placement apparatus according to the invention,
Fig. 2 is a perspective view of a component feeding device according to the invention as used in the component placement device as shown in Fig. 1,
Fig. 3 is a perspective view of a top part of the component feeding device as shown in Fig. 2,
Fig. 4 is a perspective view of a bottom part of the component feeding device as shown in Fig. 2,
Fig. 5 is a top view of the component feeding device as shown in Fig. 2 incorporated in a trolley for feeding components in trays as well as components in tapes.

Like parts are numbered alike in the figures.

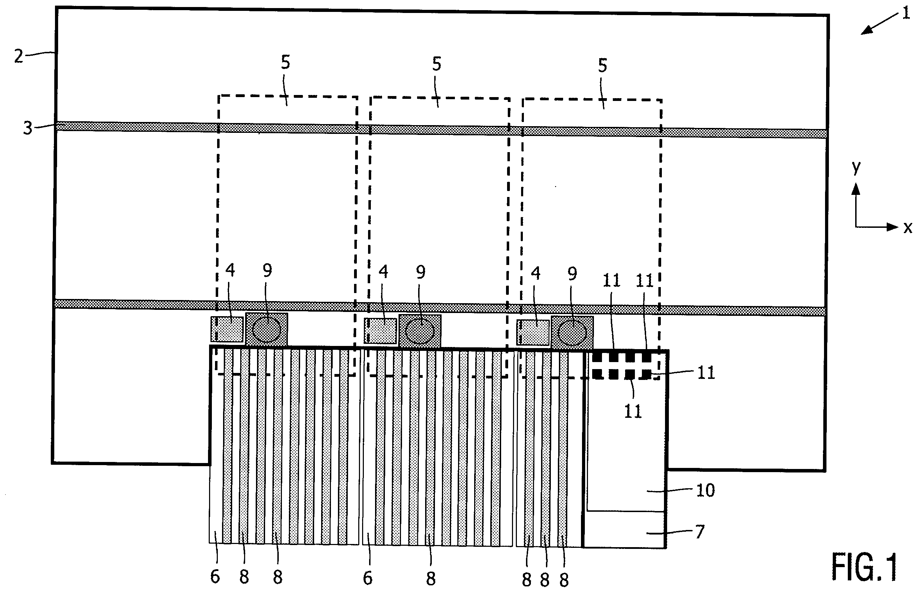

Fig. 1 shows a top view of a component placement apparatus 1 according to the invention, which apparatus is provided with a frame 2 in which a transport device 3 for transporting substrates is accommodated, which transport device can be indexed over certain distance in the positive X-direction by means which are not shown, whereupon the transport device 3 can be moved back into its starting position in the negative X-direction after said distance has been covered. Substrates like printed circuit boards can be transported through the component placement apparatus 1 by the transport device 3. The component placement apparatus 1 is furthermore provided with three pick and place devices 4 which are provided with a vacuum tube or some other pickup member, which pick and place devices 4 are movable in and opposite to the X-direction as well as in an opposite to the Y-direction in an area 5 which is indicated by dotted lines. Near each pick and place device 4 is a trolley 6, 7 located. The trolley 6 is provided with a number of reels 8 (schematically shown) provided with tapes in which components are being stored. By means of the pick and place device 4 components are subsequently picked up from one of the reels 8, after which the position of the component with respect to the pick and place device 4 is detected by means of a component alignment device 9. Subsequently the component is placed on a desired location on the substrate located in the area 5 of the respective pick and place device 4. Such a trolley 6 as well as reels 8 are known per se and will therefore not be further described.

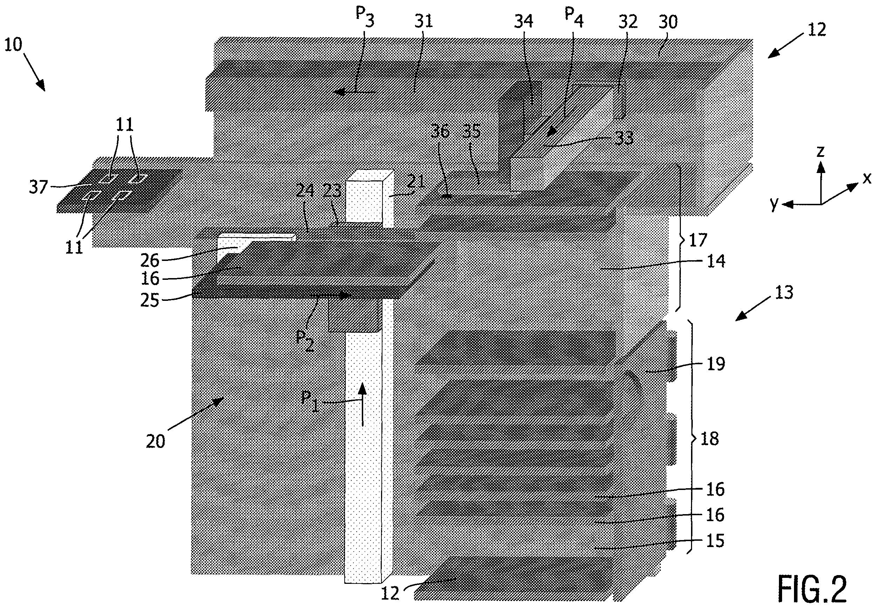

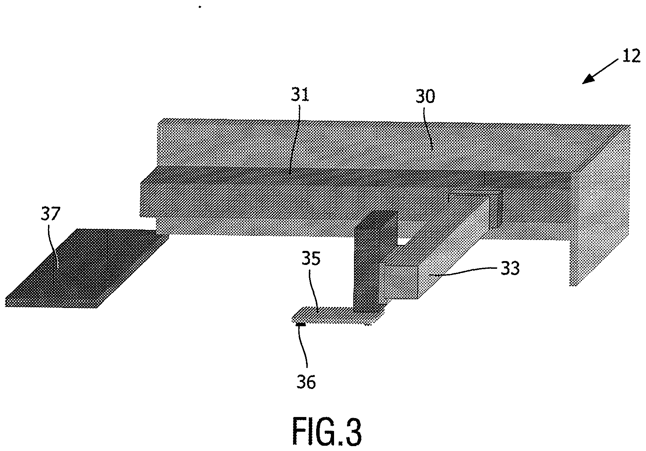

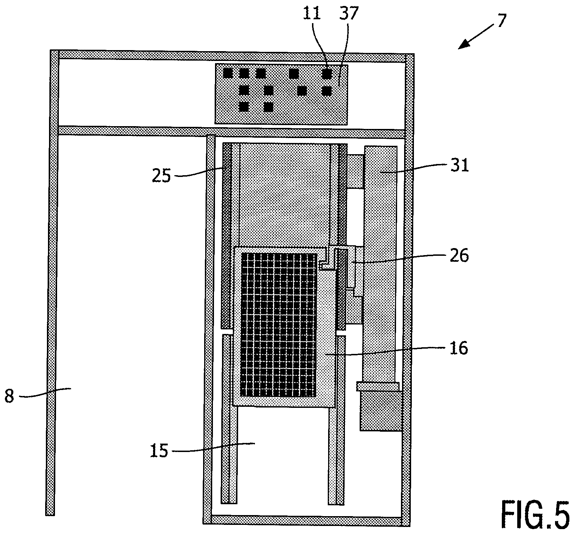

The trolley 7 also comprises reels 8 but furthermore comprises a component feeding apparatus 10 by means of which, as will be explained with reference to the Figs. 2-5, components 11 can be presented in the area 5 of the pick and place device 4, which components were stored on trays 16 in the component feeding apparatus 10.

Fig. 2 shows a perspective view of the component feeding device 10 which comprises an upper part 12 and a lower part 13. The lower part 13 comprises a tray storing device 14 with a number of slots 15 for storing trays 16 one above each other, whereby each tray 16 contains electronic components. The slots 15 in an upper first part 17 are only accessible from the interior of the tray storing device 14 whilst the slots 15 in the lower, second part 18 of the tray storing device 14 are accessible from the interior as well as by means of a door 19 from the exterior. The lower part 13 furthermore comprises a tray transporting device 20. The tray transporting device 20 has a vertical column 21 along which a guide 23 is movable in and opposite to a direction indicated by arrow P1, parallel to the Z-direction. Attached to the guide 23 is a horizontally extending beam 24 and a horizontally extending platform 25. Along the beam 24 a gripping device 26 is movable in and opposite to a direction indicated by arrow P2, parallel to the Y-direction for moving a tray 16 in and out a slot 15.

The upper part 12 of the component feeding device 10 comprises a frame 30 provided with a beam 31 extending in the Y-direction. Along the beam 31 a guide 32 is movable in and opposite to a direction indicated by arrow P3, parallel to the Y-direction. Attached to said guide 32 is a beam 33 extending parallel to the X-direction along which a guide 34 is movable in and opposite to a direction indicated by arrow P4. Attached to the guide 34 is a plate 35 carrying a pick and place device 36 like a vacuum nozzle or a gripper. The upper part 12 furthermore comprises a buffer forming substrate 37 on which components 11 are being presented to the pick and place device 4 of the component placement apparatus 1.

The operation of the component feeding device 10 according to the invention will now be explained. If no trays 16 are located in the slots 15, an operator will open door 19 and insert trays 16 in the slots 15 of the second part 18. Each tray 16 may comprise another kind of component. However, in case that one kind of component is expected to be needed in a relatively large amount, it is possible to insert a number of trays 16 with the same kind of components. The component placement apparatus 1 or the component feeding device 10 itself comprises a controller in which information is being loaded about which kind of component need to be placed on which position on a substrate by a specific pick and place device 4. From this information it is determined by the controller which components 11 need to be available on the buffer forming substrate 37 in the short term. Subsequently the platform 25 is moved by means of the guide 23 along the vertical column 21 in or opposite to the direction indicated by arrow P1 until it is aligned with a slot 15 in which a tray 16 is located comprising the relevant components. By means of the gripper 26 the tray 16 is removed from the slot 15 and moved on the platform 25 upwardly until the tray 16 is located in the same horizontal X,Y-plane as the substrate 37. This location of the tray 16 is considered to be the pickup area of the component feeding apparatus 10. Then the pick and place device 36 is moved by means of the guides 32, 34 in and opposite to the directions indicated by the arrows P3, P4 respectively to pick up a component from the tray 16 and to place this component 11 on a desired location on the buffer forming substrate 37.

Subsequently it is decided by the controller whether the tray will be needed in short term or not. If in very short term additional components from the tray 16 which is present in the pickup area are needed, these components will be placed on the buffer forming substrate 37 as well. If it is determined by means of the controller that the tray 16 will be needed at the pickup area in the short term, it is transported by means of the tray transporting device 20 to an empty slot in the first part 17 of the tray storing device 14. If it is determined by the controller that the tray 16 is empty or that the tray 16 is not expected to be needed at the pickup area in the short term, the tray 16 is transported by means of the tray transporting device 20 to an empty slot 15 in the second part 18 of the tray storing device 14.

In this manner it is possible that by means of the controller the pick and place device 36 places as many components 11 on the buffer forming substrate 37 as there are places available. These components 11 will be picked up by the pick and place device 4 to be placed on a desired location on a substrate in the area 5. If no tray 16 needs to be presented at the pickup area, it is determined by means of the controller whether the trays are already in their optimized position to be able to present the trays 16 as soon as possible to a pickup area in case that a tray 16 is needed. If it is determined by the controller that there is a tray 16 in the first part 17 which is expected not to be needed in the short term at the pickup area, this tray is being moved by means of the tray transporting device 20 in a manner described above to a slot 15 in the second part 18. In a similar way a tray 16 in the second part 18 which as determined by the controller, is expected to be needed at the pickup area in the short term is transferred to the first part 14.

In this manner trays comprising the same kind of components will all except one be located in the second part 18 whilst one of these trays will be located in the first part 17 closer to the pickup area. If this tray is emptied, it will be moved to the second part 18 whilst subsequently a full tray with the same kind of components will be moved to the first part 17. If an operator wants to replace empty trays by full trays 16 he may open the door 19. The opening of the door 19 will be detected by means of a switch (not shown) and this information will be transferred to the controller. As long as the door 19 is open the tray transporting device 20 will be controlled so that only trays 16 can be stored in the first part 17 and be removed therefrom. The operator can remove or replace only trays in the second part 18 so that any risk of interference between the tray transporting device 20 and the operator is being prevented.

If desired it is possible to even optimize the sequence of the trays 16 in the first part 17 so that the time necessary to present a tray at the pickup area and to present another tray at the pickup area is further reduced.

It is also possible to optimize the sequence of the trays in the second part 18 by means of the controller so that for example all empty trays are located in the slots 15 which are the farrest away from the pickup are whilst the trays with components are stored in the slots 15 closer to the first part 17.

By the device as shown in Fig. 1, components are displaced by means of the pick and place device 36 to the buffer forming substrate 37 and subsequently moved by means of the pick and place device 4 to a desired position on a substrate.

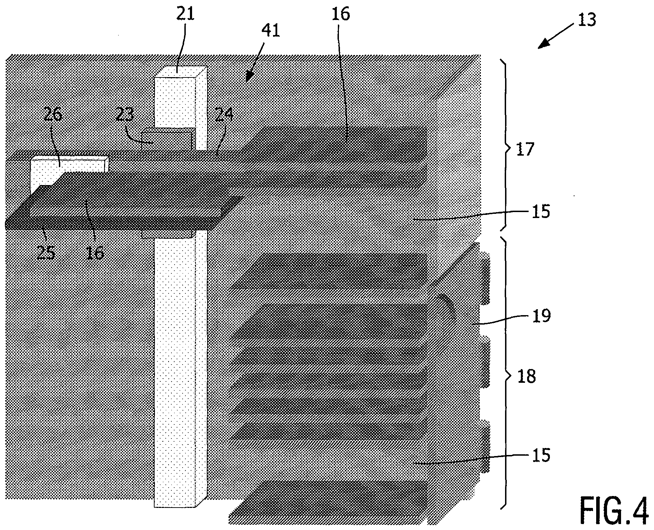

However, it is also possible to use only the component feeding device 13 as shown in Fig. 4 whereby the tray 16 is presented in a pickup area 41, whereby this pickup area 41 is accessible by means of the pick and place device 4. Such a component feeding device is less expensive than the component feeding device comprising also the pick and place device 36. This will be suitable if only occasionally a component from a tray 16 is needed. Otherwise it will be preferable to use the component feeding device 10 whereby a buffer of components 11 on a buffer forming substrate 37 can be formed due to which the time necessary for the pick and place device to pick up a component 11 coming from a tray will be shorter.

Although it is preferred that the tray transporting device is being moved along the slots, it is also foreseen that the tray storing device 14 is being moved up and down, whereby the trays which are needed on the short term are located in the middle part, the trays which are emptied are stored in the lower part and the trays which are provided with components which are expected not to be needed in the short term are located in an upper part of the tray storing device 14.

It is also possible to provide the tray storing device with a third part, located on the left side of the vertical column 21 (Fig. 4) and located below the transport device 3. The third part can be filled with trays in a manner similar as the first part 17. In said third part trays can be stored which are not expected to be needed in the short term.

It is also possible to use the tray storing device for storing stacks of trays, whereby a single tray can be removed from the stack loaded in the upper part whilst the remaining part of the stack is stored in the lower part.

It is also possible to use the tray storing device for storing wafers carrying components.

## Claims

1. Component placement apparatus (1) comprising a tray storing device (14) with slots for storing trays containing electronic components (11), a tray transporting device (20) for transporting a tray (16) from the tray storing device (14) to a pickup area, a controller for controlling the transport from the trays (16) in and out the tray storing device (14) and at least one component pick and place device (4, 36) for picking up a component (11) from the tray (16) located in the pickup area and placing the component (11) on a substrate,
wherein the tray storing device (14) comprises a first part (17) comprising slots (15) for storing trays (16) expected to be needed at the pickup area in the short term, which first part (17) is located close to the pickup area, whilst the tray storing device (14) comprises a second part (18) comprising slots (15) for storing trays (16) which are empty or not expected to be needed in the pickup area in the short term which second part (18) is located further away from the pickup area, whereby the controller comprises means for determining whether a tray (16) that is at the pick-up area and after a component (11) has been removed from said tray (16) at the pickup area will be needed at the pickup in the short term and should be stored in an empty slot (15) of the first part (17) or whether said tray (16) is empty or not expected to be needed in the pickup area in the short term and should be stored in an empty slot (15) of the second part (18).

2. Component placement apparatus (1) according to claim 1,
**characterized in that** the component placement apparatus (1) is provided with safety means which allow trays (16) to be transported by the tray transporting device (20) from the first part (17) to the pickup area and vice versa while simultaneously trays (16) in the second part (18) can be removed from the tray storing device (14) and/or new trays (16) can be inserted in the second part (18).

3. Component placement apparatus (1) according to claim 2,
**characterized in that** by the safety means, the tray transporting device (20) is prevented from transporting trays (16) from the second part (18), during removal to the exterior and/or insertion from the exterior of trays (16) in the second part.

4. Component placement apparatus (1) according to one of the preceding claims, **characterized in that** a component (11) can be picked up from the tray (16) located in the pickup area by means of the pick and place device (36) and can be placed on the substrate forming a buffer, whilst the component placement apparatus (1) comprises a further pick and place device (4) by means of which the component (11) placed on the buffer forming substrate can be transferred to another substrate.

5. Component placement apparatus (1) according to claim 4, **characterized in that** several components (11) can be located simultaneously on the buffer forming substrate.

6. Component placement apparatus (1) according to one of the preceding claims, **characterized in that** the tray storing device (14) is stationary whilst the tray transporting device (20) is movable along the slots of the tray storing device (14).

7. Method for optimizing the operation of a component feeding device which component feeding device comprises a tray storing device (14) with slots for storing trays containing electronic components (11), a tray transporting device (20) for transporting a tray (16) from the tray storing device (14) to a pickup area and a controller for controlling the transport from trays (16) in and out the tray storing device (14),
wherein
a plurality of trays (16) comprising components (11) are inserted in the slots of the tray storing device (14), whereby at least one slot is empty, after which a tray (16) is being moved under control of the controller by means of the tray transport device to the pickup area at which location a component (11) is being removed from the tray (16), subsequently it is determined by means of the controller whether the tray (16) that is at the pick-up area and after a component (11) has been removed from said tray (16) at the pickup area will be needed at the pickup area in the short term after which said tray (16) is stored in an empty slot of a first part (17) of the tray storing device (14) relatively close to the pickup area or whether said tray (16) is empty or not expected to be needed in the pickup area in the short term and is stored in an empty slot of a second part (18) of the tray storing device (14) located further away from the pickup area.

8. Method according to claim 8, **characterized in that** by means of the tray transporting device (20) a tray (16) in the second part (18), which is expected to be needed at the pickup area in the short term is transferred to a slot in the first part (17).

9. Method according to claim 8 or claim 9, **characterized in that** by means of the tray transporting device (20) a tray (16) in the first part (17) which is expected not to be needed in the pickup area in the short term is transferred to a slot in the second part (18).

10. Method according to one of the preceding claims 8-10, **characterized in that** empty trays (16) in slots in the second part (18) are removed from the tray storing device (14) whilst simultaneously trays (16) in the first part (17) are being transported to and from the pickup area.

11. Method according to one of the preceding claims 8-11, **characterized in that** new trays (16) are inserted from the exterior in slots of the second part (18) whilst simultaneously trays (16) in the first part (17) are being transported to and from the pickup area.

12. Method according to one of the preceding claims nor 12, **characterized in that** by means of the controller the trays transport device is prevented from transporting trays (16) from slots in the second part (18) during removal and/or insertion from trays (16) in the second part (18).

## Patentansprüche

1. Bestückungsautomat (1), umfassend ein Tablarlager (14) mit Schlitzen zum Lagern von Tablaren mit elektronischen Bauteilen (11), einen Tablarförderer (20) zum Fördern eines Tablars (16) vom Tablarlager (14) zu einem Aufnahmebereich, einen Controller zur Steuerung des Förderns von den Tablaren (16) in das Tablarlager (14) und aus diesem heraus, und mindestens eine Bestückungsvorrichtung (4, 36) zum Aufnehmen eines Bauteils (11) von dem im Aufnahmebereich befindlichen Tablar (16) und Ablegen des Bauteils (11) auf einen Träger, wobei das Tablarlager (14) einen ersten Abschnitt (17) mit Schlitzen (15) zum Lagern von Tablaren (16) umfasst, die voraussichtlich kurzfristig im Aufnahmebereich benötigt werden, wobei der erste Abschnitt (17) nahe beim Aufnahmebereich gelegen ist, und wobei das Tablarlager (14) einen zweiten Abschnitt (18) mit Schlitzen (15) zum Lagern von Tablaren (16) umfasst, die leer sind oder die voraussichtlich nicht kurzfristig im Aufnahmebereich benötigt werden, wobei der zweite Abschnitt (18) weiter entfernt vom Aufnahmebereich gelegen ist, wobei der Controller Mittel umfasst, um festzustellen, ob ein Tablar (16) im Aufnahmebereich und nach Entfernen eines Bauteils (11) von diesem Tablar (16) im Aufnahmebereich kurzfristig im Aufnahmebereich benötigt werden wird und in einem leeren Schlitz (15) des ersten Abschnitts (17) gelagert werden sollte, oder ob dieses Tablar (16) leer ist oder voraussichtlich nicht kurzfristig im Aufnahmebereich benötigt wird und in einem leeren Schlitz (15) des zweiten Abschnitts (18) gelagert werden sollte.

2. Bestückungsautomat (1) nach Anspruch 1, **dadurch gekennzeichnet, dass** der Bestückungsautomat (1) mit Sicherheitsmitteln versehen ist, die es ermöglichen, Tablare (16) durch den Tablarförderer (20) vom ersten Abschnitt (17) zum Aufnahmebereich und umgekehrt zu fördern, während gleichzeitig Tablare (16) im zweiten Abschnitt (18) aus dem Tablarlager (14) entfernt und/oder neue Tablare (16) in den zweiten Abschnitt (18) eingesetzt werden können.

3. Bestückungsautomat (1) nach Anspruch 2, **dadurch gekennzeichnet, dass** die Sicherheitsmittel den Tablarförderer (20) während des Entfernens und/oder Einsetzens von Tablaren (16) aus dem/in den zweiten Abschnitt (18) daran hindern, Tablare (16) aus dem zweiten Abschnitt (18) zu fördern.

4. Bestückungsautomat (1) nach einem der vorangehenden Ansprüche, **dadurch gekennzeichnet, dass** ein Bauteil (11) von dem im Aufnahmebereich sich befindenden Tablar (16) mittels der Bestückungsvorrichtung (36) aufgenommen und auf einem Pufferträger abgelegt werden kann, während der Bestückungsautomat (1) eine weitere Bestückungsvorrichtung (4) umfasst, mit der das auf dem Pufferträger abgelegte Bauteil (11) auf einen anderen Träger überführt werden kann.

5. Bestückungsautomat (1) nach Anspruch 4, **dadurch gekennzeichnet, dass** auf dem Pufferträger mehrere Bauteile (11) gleichzeitig untergebracht werden können.

6. Bestückungsautomat (1) nach einem der vorangehenden Ansprüche, **dadurch gekennzeichnet, dass** das Tablarlager (14) stationär ist, während der Tablarförderer (20) an den Schlitzen des Tablarlagers (14) entlang bewegbar ist.

7. Verfahren zur Optimierung des Betriebs einer Bauteilezuführvorrichtung, wobei die Bauteilezuführvorrichtung ein Tablarlager (14) mit Schlitzen zur Lagerung von Tablaren mit elektronischen Bauteilen (11), einen Tablarförderer (20) zum Fördern eines Tablars (16) vom Tablarlager (14) zu einem Aufnahmebereich und einen Controller zur Steuerung der Förderung von Tablaren in den und aus dem Tablarförderer (14) umfasst, wobei in die Schlitze des Tablarlagers (14) eine Mehrzahl von Tablaren (16) mit Bauteilen (11) eingesetzt sind, wobei mindestens ein Schlitz leer ist, wonach ein Tablar (16) gesteuert durch den Controller mittels des Tablarförderers zum Aufnahmebereich gefördert wird, wo ein Bauteil (11) vom Tablar (16) entfernt wird; danach wird durch den Controller festgestellt, ob das Tablar (16) im Aufnahmebereich nach Entnehmen eines Bauteils (11) von diesem Tablar (16) im Aufnahmebereich dort kurzfristig benötigt wird, wonach dieses Tablar (16) in einem leeren Schlitz des ersten Abschnitts (17) des Tablarlagers (14) relativ nah zum Aufnahmebereich gelagert wird, oder ob dieses Tablar (16) leer ist oder voraussichtlich nicht kurzfristig im Aufnahmebereich benötigt und in einem leeren Schlitz des zweiten Abschnitts (18) des Tablarlagers (14) weiter entfernt vom Aufnahmebereich gelagert wird.

8. Verfahren nach Anspruch 7, **dadurch gekennzeichnet, dass** ein Tablar (16) im zweiten Abschnitt (18), das voraussichtlich kurzfristig im Aufnahmebereich benötigt wird, mittels des Tablarförderers (20) in einen Schlitz im ersten Abschnitt (17) überführt wird.

9. Verfahren nach Anspruch 7 oder 8, **dadurch gekennzeichnet, dass** ein Tablar (16) im ersten Abschnitt (17), das voraussichtlich nicht kurzfristig im Aufnahmebereich benötigt wird, mittels des Tablarförderers (20) in einen Schlitz im zweiten Abschnitt (18) überführt wird.

10. Verfahren nach einem der vorangehenden Ansprüche 7-9, **dadurch gekennzeichnet, dass** leere Tablare (16) in Schlitzen im zweiten Abschnitt (18) aus dem Tablarlager (14) entfernt werden, während gleichzeitig Tablare (16) im ersten Abschnitt (17) in den Aufnahmebereich und aus diesem heraus gefördert werden.

11. Verfahren nach einem der vorangehenden Ansprüche 7-10, **dadurch gekennzeichnet, dass** neue Tablare (16) von außen in Schlitze des zweiten Abschnitts (18) eingesetzt werden, während gleichzeitig Tablare (16) im ersten Abschnitt (17) in den Aufnahmebereich und aus diesem heraus gefördert werden.

12. Verfahren nach einem der vorangehenden Ansprüche 10 oder 11, **dadurch gekennzeichnet, dass** während des Entfernens und/oder Einsetzens von Tablaren (16) in den zweiten Abschnitt (18) der Tablarförderer durch den Controller am Fördern von Tablaren (16) aus Schlitzen im zweiten Abschnitt (18) gehindert wird.

## Revendications

1. Appareil de placement de composants (1) comprenant un dispositif de stockage de plateaux (14) avec des fentes pour stocker des plateaux contenant des composants électroniques (11), un dispositif de transport de plateau (20) pour transporter un plateau (16) du dispositif de stockage de plateaux (14) à une zone de réception, un dispositif de commande pour commander le transport des plateaux (16) dans et hors du dispositif de stockage de plateaux (14) et au moins un dispositif de réception et de mise en place de composant (4, 36) pour réceptionner un composant (11) du plateau (16) situé dans la zone de réception et placer le composant (11) sur un substrat, dans lequel le dispositif de stockage de plateaux (14) comprend une première partie (17) comprenant des fentes (15) pour stocker des plateaux (16) attendus comme étant nécessaires au niveau de la zone de réception à court terme, laquelle première partie (17) est située à proximité de la zone de réception, tandis que le dispositif de stockage de plateaux (14) comprend une seconde partie (18) comprenant des fentes (15) pour stocker des plateaux (16) qui sont vides ou non attendus comme étant nécessaires dans la zone de réception à court terme, laquelle seconde partie (18) est située plus loin de la zone de réception, moyennant quoi le dispositif de commande comprend un moyen pour déterminer si un plateau (16) qui est au niveau de la zone de réception, et après qu'un composant (11) a été retiré dudit plateau (16) au niveau de la zone de réception, sera nécessaire au niveau de la réception à court terme et devrait être stocké dans une fente vide (15) de la première partie (17) ou si ledit plateau (16) est vide ou non attendu comme étant nécessaire dans la zone de réception à court terme et devrait être stocké dans une fente vide (15) de la seconde partie (18).

2. Appareil de placement de composants (1) selon la revendication 1, **caractérisé en ce que** l'appareil de placement de composants (1) est doté d'un moyen de sécurité qui permet aux plateaux (16) d'être transportés par le dispositif de transport de plateau (20) de la première partie (17) à la zone de réception et vice versa pendant que simultanément les plateaux (16) dans la seconde partie (18) peuvent être retirés du dispositif de stockage de plateaux (14) et/ou de nouveaux plateaux (16) peuvent être insérés dans la seconde partie (18).

3. Appareil de placement de composants (1) selon la revendication 2, **caractérisé en ce que** par le moyen de sécurité, le dispositif de transport de plateau (20) est empêché de transporter des plateaux (16) à partir de la seconde partie (18), durant le retrait vers l'extérieur et/ou l'insertion à partir de l'extérieur de plateaux (16) dans la seconde partie.

4. Appareil de placement de composants (1) selon l'une des revendications précédentes, **caractérisé en ce qu'**un composant (11) peut être réceptionné à partir du plateau (16) situé dans la zone de réception au moyen du dispositif de réception et de mise en place (36) et peut être placé sur le substrat formant un tampon, tandis que l'appareil de placement de composants (1) comprend un dispositif de réception et de mise en place (4) supplémentaire au moyen duquel le composant (11) placé sur le substrat formant tampon peut être transféré sur un autre substrat.

5. Appareil de placement de composants (1) selon la revendication 4, **caractérisé en ce que** plusieurs composants (11) peuvent être situés simultanément sur le substrat formant tampon.

6. Appareil de placement de composants (1) selon l'une des revendications précédentes, **caractérisé en ce que** le dispositif de stockage de plateaux (14) est stationnaire tandis que le dispositif de transport de plateau (20) est mobile le long des fentes du dispositif de stockage de plateaux (14).

7. Procédé d'optimisation du fonctionnement d'un dispositif d'alimentation en composants, lequel dispositif d'alimentation en composants comprend un dispositif de stockage de plateaux (14) avec des fentes pour stocker des plateaux contenant des composants électroniques (11), un dispositif de transport de plateau (20) pour transporter un plateau (16) du dispositif de stockage de plateaux (14) à une zone de réception et un dispositif de commande pour commander le transport des plateaux (16) dans et hors du dispositif de stockage de plateaux (14), dans lequel une pluralité de plateaux (16) comprenant des composants (11) sont insérés dans les fentes du dispositif de stockage de plateaux (14), moyennant quoi au moins une fente est vide, après quoi un plateau (16) est déplacé sous la commande du dispositif de commande au moyen du dispositif de transport de plateau jusqu'à la zone de réception au niveau duquel un composant (11) est retiré du plateau (16), ensuite il est déterminé au moyen du dispositif de commande si le plateau (16) qui est au niveau de la zone de réception et après qu'un composant (11) a été retiré dudit plateau (16) au niveau de la zone de réception sera nécessaire au niveau de la zone de réception à court terme après quoi ledit plateau (16) est stocké dans une fente vide d'une première partie (17) du dispositif de stockage de plateaux (14) relativement proche de la zone de réception ou si ledit plateau (16) est vide ou non attendu comme étant nécessaire dans la zone de réception à court terme et est stocké dans une fente vide d'une seconde partie (18) du dispositif de stockage de plateaux (14) située plus loin de la zone de réception.

8. Procédé selon la revendication 7, **caractérisé en ce qu'**au moyen du dispositif de transport de plateau (20), un plateau (16) dans la seconde partie (18), qui est attendu comme étant nécessaire au niveau de la zone de réception à court terme est transféré dans une fente dans la première partie (17).

9. Procédé selon la revendication 7 ou la revendication 8, **caractérisé en ce qu'**au moyen du dispositif de transport de plateau (20) un plateau (16) dans la première partie (17) qui est attendu comme n'étant pas nécessaire dans la zone de réception à court terme est transféré dans une fente dans la seconde partie (18).

10. Procédé selon l'une des revendications 7 à 9 précédentes, **caractérisé en ce que** des plateaux vides (16) dans des fentes dans la seconde partie (18) sont retirés du dispositif de stockage de plateaux (14) tandis que simultanément des plateaux (16) dans la première partie (17) sont transportés vers et depuis la zone de réception.

11. Procédé selon l'une des revendications 7 à 10 précédentes, **caractérisé en ce que** de nouveaux plateaux (16) sont insérés depuis l'extérieur dans des fentes de la seconde partie (18) tandis que simultanément des plateaux (16) dans la première partie (17) sont transportés vers et depuis la zone de réception.

12. Procédé selon l'une des revendications 10 ou 11 précédentes, **caractérisé en ce qu'**au moyen du dispositif de commande le dispositif de transport de plateaux est empêché de transporter des plateaux (16) à partir des fentes dans la seconde partie (18) durant le retrait et/ou l'insertion des plateaux (16) dans la seconde partie (18).
